(19) Europäisches Patentamt
European Patent Office
Office européen des brevets

(11) **EP 4 160 701 A1**

(12) **EUROPEAN PATENT APPLICATION**
published in accordance with Art. 153(4) EPC

(43) Date of publication:
**05.04.2023 Bulletin 2023/14**

(21) Application number: **21872713.9**

(22) Date of filing: **11.08.2021**

(51) International Patent Classification (IPC):
**H01L 33/24** (2010.01)    **H01L 25/075** (2006.01)
**H01L 33/36** (2010.01)    **H01L 33/40** (2010.01)
**H01L 33/44** (2010.01)

(52) Cooperative Patent Classification (CPC):
**H01L 25/075; H01L 33/24; H01L 33/36;
H01L 33/40; H01L 33/44**

(86) International application number:
**PCT/KR2021/010670**

(87) International publication number:
**WO 2022/065683 (31.03.2022 Gazette 2022/13)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **23.09.2020 KR 20200122896**

(71) Applicant: **Samsung Electronics Co., Ltd.
Gyeonggi-do 16677 (KR)**

(72) Inventors:
• **KANG, Jihoon**
  **Suwon-si Gyeonggi-do 16677 (KR)**
• **SUH, Jenghun**
  **Suwon-si Gyeonggi-do 16677 (KR)**
• **OTA, Jitsuo**
  **Suwon-si Gyeonggi-do 16543 (KR)**
• **KIM, Myunghee**
  **Suwon-si Gyeonggi-do 16677 (KR)**

(74) Representative: **Appleyard Lees IP LLP
15 Clare Road
Halifax HX1 2HY (GB)**

(54) **MICRO LED AND DISPLAY MODULE HAVING SAME**

(57)    Disclosed are a micro LED and a display module including same, the micro LED comprising: a light-emitting surface; and a first electrode and a second electrode arranged on a surface opposite to the light-emitting surface. The disclosed micro LED comprises: a current diffusion layer to which the first electrode is electrically connected, and which has the light-emitting surface; a first cladding layer and a second cladding layer that are stacked on the current diffusion layer; an active layer arranged between the first cladding layer and the second cladding layer; and a current guiding unit arranged between the second electrode and the second cladding layer, and formed from a side surface of the micro LED to a position adjacent to the central part of the micro LED so that current flows while spaced from the side surface of the micro LED.

FIG. 3

## Description

[TECHNICAL FIELD]

The present disclosure relates to a micro light emitting diode (LED) and a display module having the same, and more particularly, to a micro light emitting diode (LED) having a structure to control a current path, and a display module having the plurality of micro LEDs mounted on a thin film transistor (TFT) substrate.

CROSS-REFERENCE TO RELATED APPLICATIONS

This application is based on and claims priority under 35 U.S.C. §119 to Korean Patent Application No. 10-2020-0122896, filed on September 23, 2020, in the Korean Intellectual Property Office, the disclosure of which is incorporated by reference herein in its entirety.

[BACKGROUND ART]

A light emitting diode (LED) has been applied in various industrial fields due to its relatively high luminous efficiency and long lifespan. In particular, the LEDs are put to practical use in display fields as well as general lighting.

Micro LEDs of at least three red/green/blue (R/G/B) colors are integrated in one pixel in a LED display (for example, a full-color micro LED display) developed these days. However, a demand for improving luminous efficiency of the LED device has been continued with a trend of high performance and high efficiency of the display. In particular, in a field of developing ultra-small LEDs such as the micro LEDs, the improvement of the luminous efficiency of LEDs is emerging as an important solution along with the improvement of process efficiency.

Non-radiative recombination may occur around a side surface of the micro LED, formed by mesa etching during the manufacturing process. The non-radiative recombination is known to reduce a quantum efficiency of the micro LED.

The mesa etching is a plasma-based dry etching. A high-density defect may occur on the side surface of the micro LED formed by the dry etching.

In addition, in a passivation process which is a process subsequent to the dry etching process, an insulating material (e.g., silicon dioxide ($SiO_2$), aluminum oxide ($Al_2O_3$) , or silicon nitride (SiN)) may be deposited on the side surface of the micro LED. The mesa-etched side surface of the micro LED may be further damaged during the passivation process. These defects may lower the quantum efficiency and thermal stability of the LED along with the non-radiative recombination. In particular, a ratio of a defective surface area to the side surface of the micro LED may be large, thus lowering its efficiency and thermal stability.

It is preferable that a current flows away from the side surface of the micro LED to suppress the non-radiative recombination occurring on the side surface. To this end, it is preferable to have a highly resistive area or a wide band gap area positioned from the side surface of the micro LED to a certain part inside the micro LED.

In this regard, the highly resistive area or the wide band gap area may be formed by any of several techniques such as dry etching, ion implantation and regrowth techniques. In this case, the micro LED may have high-density damage or impurities occurring in its outer area (highly resistive area or wide band gap area) and/or around an interface between the outer area and an inner area (area positioned in the highly resistive area or wide band gap area). Here, the inner area may refer to an area where a current spreading layer, a cladding layer, and an active layer are located, and the side surface of the micro LED is covered by the outer area. In particular, the active layer of the micro LED may be damaged due to a process of forming its outer area, thereby lowering the luminous efficiency of the micro LED.

In addition, the current spreading layer may lead to spread of an injected current toward the wide side surface due to its low resistivity, a current spreading width of the active layer may thus be often full in the inner area, and a carrier may thus reach the defective interface between the inner area and the outer area. Therefore, a conventional micro LED may have an undesirable non-radiative recombination phenomenon occurring in the defective outer area even when the current flows away from the mesa-etched side surface thereof. Due to these problems, there has been a significant limit for the conventional micro LED to have the improved luminous efficiency and thermal stability.

[DISCLOSURE]

[TECHNICAL PROBLEM]

Provided are a micro light emitting diode (LED) having improved luminous efficiency and thermal stability by omitting additional processes such as ion implantation and regrowth of an outer area of an active layer after its mesa etching process, and by including a current guiding part controlling a current flowing from an electrode to the active layer to be as far away as possible from a side surface of the micro LED, a display module having the same, and a method for manufacturing the micro LED.

[TECHNICAL SOLUTION]

According to an embodiment of the present disclosure, a micro light emitting diode (LED) in which a first electrode and a second electrode are respectively disposed on a light-emitting surface thereof and a surface opposite to the light-emitting surface, includes: a current spreading layer electrically connected to the first electrode and having the light-emitting surface; a first cladding layer and a second cladding layer, stacked on the current spreading layer; an active layer disposed between the first cladding layer and the second cladding layer; and a current guiding part disposed between the second electrode and the second cladding layer, and positioned from a side surface of the micro LED to a position of the micro LED, adjacent to a central part thereof, for a current to flow away from the side surface of the micro LED.

The second electrode may have a lateral length greater than a lateral length of an area of the current guiding part, through which the current passes, to cover the area through which the current passes and a portion of the current guiding part adjacent to the area through which the current passes.

A semiconductor layer may serve as the area of the current guiding part, through which the current passes.

A carrier concentration of the second cladding layer may be less than 5E+17/cm3.

The first electrode and the second electrode may each be made of any one of aluminum (Al), titanium (Ti), chromium (Cr), nickel (Ni), palladium (Pd), silver (Ag), germanium (Ge), gold (Au), or an alloy thereof.

A first semiconductor contact layer made of an electrically conductive oxide may be positioned between the first electrode and the current spreading layer, and a second semiconductor contact layer made of the electrically conductive oxide may be positioned between the second electrode and the semiconductor layer.

The first and second semiconductor contact layers may each be made of indium tin oxide (ITO) or zinc oxide (ZnO).

The micro LED may further include a passivation layer stacked on the side surface of the micro LED, and the passivation layer may be made of any one of alumina (Al2O3), silica (SiO2), and silicon nitride (SiN).

The current guiding part is made of any one of alumina (Al2O3), silica (SiO2), and silicon nitride (SiN).

The micro LED may further include: a first semiconductor layer serving as the area of the current guiding part, through which the current passes; and a second semiconductor layer covering the first semiconductor layer and the current guiding part, and electrically connected to the second electrode.

A carrier concentration of the second semiconductor layer may be greater than or equal to a carrier concentration of the second cladding layer.

The second electrode may have a lower portion inserted into the current guiding part and electrically connected to the second cladding layer, and an upper portion protruding higher than an upper surface of the current guiding part and having a lateral length greater than a lateral length of an area through which the current passes to cover a portion adjacent to the area through which the current passes.

According to another embodiment of the present disclosure, a micro light emitting diode (LED) in which a first electrode and a second electrode are respectively disposed on a light-emitting surface thereof and a surface opposite to the light-emitting surface, includes: a current spreading layer electrically connected to the first electrode and having the light-emitting surface; a first cladding layer and a second cladding layer, stacked on the current spreading layer; an active layer disposed between the first cladding layer and the second cladding layer; a current guiding part disposed between the second electrode and the second cladding layer, and positioned from a side surface of the micro LED to a position of the micro LED, adjacent to a central part thereof, for a current to flow away from the side surface of the micro LED; and a passivation layer stacked on the side surface of the micro LED, wherein the second electrode has a lateral length greater than a lateral length of an area of the current guiding part, through which the current passes, to cover the area through which the current passes and a portion adjacent to the area through which the current passes.

A semiconductor layer may serve as the area of the current guiding part, through which the current passes.

The micro LED may further include: a first semiconductor layer serving as the area of the current guiding part, through which the current passes; and a second semiconductor layer covering the first semiconductor layer and the current guiding part, and electrically connected to the second electrode.

The second electrode may have a lower portion inserted into the current guiding part and electrically connected to the second cladding layer, and an upper portion protruding higher than an upper surface of the current guiding part and having the lateral length greater than the lateral length of the area through which the current passes to cover the portion adjacent to the area through which the current passes.

According to still another embodiment of the present disclosure, a display module includes: a thin film transistor (TFT) substrate including a glass substrate and a TFT layer positioned on one surface of the glass substrate; and a plurality of micro light emitting diodes (LEDs) electrically connected to a plurality of TFT electrodes positioned on the TFT layer, wherein each of the plurality of micro LEDs has a first electrode and a second electrode on a surface opposite to a light-emitting surface thereof, the micro LED includes: a current spreading layer electrically connected to the first electrode and having the light-emitting surface; a first cladding layer and a second cladding layer, stacked on the current spreading layer; an active layer disposed between the first cladding layer and the second cladding layer; a current guiding part disposed between the second electrode and the second cladding layer, and positioned from a side surface of the micro LED to a position of the micro LED, adjacent to a central part thereof, for a current to flow away from the side surface of the micro LED; and a passivation layer stacked on the side surface of the micro LED, and the second electrode has a lateral length greater than a lateral length of an area of the current guiding part, through which the current passes, to cover the area through which the current passes and a portion adjacent to the area through which the current passes.

[DESCRIPTION OF DRAWINGS]

FIG. 1 is a plan view showing a display module including a plurality of pixels each having a red/green/blue (R/G/B) sub-pixel according to an embodiment of the present disclosure.

FIG. 2 is a schematic view showing a side surface of the pixel included in the display module according to an embodiment of the present disclosure.

FIG. 3 is a schematic view showing a micro light emitting diode (LED) according to an embodiment of the present disclosure.

FIG. 4 is a flowchart showing a manufacturing process of the micro LED according to an embodiment of the present disclosure.

FIGS. 5A to 5F are process views sequentially showing the manufacturing process of the micro LED according to an embodiment of the present disclosure.

FIG. 6 is a schematic view showing a micro LED according to another embodiment of the present disclosure.

FIG. 7 is a flowchart showing a manufacturing process of the micro LED according to another embodiment of the present disclosure.

FIGS. 8A to 8F are process views sequentially showing the manufacturing process of the micro LED according to another embodiment of the present disclosure.

FIG. 9 is a schematic view showing a micro LED according to still another embodiment of the present disclosure.

FIG. 10 is a flowchart showing a manufacturing process of the micro LED according to still another embodiment of the present disclosure.

FIGS. 11A to 11F are process views sequentially showing the manufacturing process of the micro LED according to still another embodiment of the present disclosure.

FIG. 12 is a graph comparing current spreading widths of p-type AlInP semiconductor layers in the micro LEDs according to the present disclosure and a conventional micro LED.

FIG. 13A is a graph showing an example of a simulation curve for a micro LED emitting red light according to the present disclosure.

FIG. 13B is a graph showing an example of a temperature dependence of a light intensity ratio for the red micro LED according to the present disclosure.

[BEST MODE]

Hereinafter, various embodiments will be described in more detail with reference to the accompanying drawings. Embodiments described in this specification may be variously modified. A specific embodiment may be illustrated in the drawings and described in detail in a detailed description. However, the specific embodiment shown in the accompanying drawings is provided only to allow various embodiments to be easily understood. Therefore, it should be understood that the spirit of the present disclosure is not limited by the specific embodiment shown in the accompanying drawings, and includes all the equivalents and substitutions included in the spirit and scope of the present disclosure.

Terms including ordinal numbers such as 'first' and 'second' may be used to describe various components. However, these components are not limited by these terms. The terms are used only to distinguish one component from another component.

It should be understood that terms 'include' and 'comprise' used in this specification specify the presence of features, numerals, steps, operations, components, parts mentioned in this specification, or combinations thereof, and do not preclude the presence or addition of one or more other features, numerals, steps, operations, components, parts, or combinations thereof.

In describing the present disclosure, summarized or omitted is a detailed description of a case where it is decided that the detailed description for the known functions or configurations related to the present disclosure may unnecessarily obscure the gist of the present disclosure.

In the present disclosure, a glass substrate may have a front surface on which a thin film transistor (TFT) layer having a TFT circuit positioned thereon is disposed, and a rear surface on which a driving circuit for driving the TFT circuit of the TFT layer is disposed. The glass substrate may be a quadrangle type. In detail, the glass substrate may have a rectangular shape or a square shape.

In the present disclosure, a substrate in which the TFT layer is stacked on the glass substrate may be referred to as a TFT substrate (or backplane). The TFT substrate is not limited to a specific structure or type, for example, the TFT substrate cited in the present disclosure may be implemented using an oxide TFT, silicon (Si, poly silicon or a-silicon) TFT, an organic TFT, a graphene TFT or the like in addition to a low temperature polycystalline silicon (LTPS) TFT; or use only a P-type (or N-type) metal oxide semiconductor field effect transistor (MOSFET) manufactured in a silicon (Si) wafer complementary metal oxide semiconductor (CMOS) process.

In the present disclosure, the front surface of the glass substrate, on which the TFT layer is disposed, may be divided into an active area and a dummy area. The active area may be an area occupied by the TFT layer on one surface of the glass substrate, and the dummy area may be an edge area on the one surface of the glass substrate. The edge area may include a side surface of the glass substrate. In addition, the edge area may be a remaining area other than the area on the front surface of the glass substrate, in which the TFT circuit is disposed and an area on the rear surface of the glass substrate, in which the driving circuit is disposed. In addition, the edge area may include the side surface of the glass substrate and portions of the front surface and rear surface of the glass substrate, adjacent to the side surface.

In the present disclosure, a glass substrate may have a plurality of front connection pads positioned on the front surface thereof and electrically connected to the TFT circuit through wiring, and a plurality of rear connection pads positioned on the rear surface thereof and electrically connected to the driving circuit through wiring. The plurality of front and rear connection pads may respectively be disposed to be drawn into the glass substrate by a predetermined distance from the side surface of the glass substrate. The connection pads respectively positioned on the front surface and rear surface of the glass substrate may be in electrical connection by side wiring positioned in the edge area of the glass substrate.

In the present disclosure, a plurality of pixels may be positioned on the TFT layer of the glass substrate. Each pixel may include a plurality of sub-pixels, and one sub-pixel may correspond to one micro light emitting diode (LED). The TFT layer may include the TFT circuit for driving each pixel. The micro LED may be a semiconductor chip which is made of an inorganic light emitting material and may emit light by itself when power is supplied thereto. In addition, the micro LED may have a flip chip structure in which anode and cathode electrodes are positioned on the same surface and a light-emitting surface is positioned opposite to the electrode.

In the present disclosure, the TFT layer stacked on the glass substrate may be electrically connected to the micro LED. In detail, an electrode pad of the micro LED may be electrically connected to the electrode pad on the TFT layer, and the electrode of the micro LED and a TFT electrode may be connected to each other through metal bonding.

In the present disclosure, a display module including the micro LEDs may be a flat panel display panel. The micro LED may be an inorganic LED having a size of 100 um or less. The display module including the micro LEDs may provide better contrast, faster response time and higher energy efficiency compared to a liquid crystal display (LCD) panel that requires a backlight. Both an organic light emitting diode (OLED), which is an organic light emitting device, and the micro LED, which is the inorganic light emitting device, may have good energy efficiency. However, the micro LED may have longer brightness, higher luminous efficiency, and longer lifespan than the OLED.

In the present disclosure, the micro LEDs may be the plurality of independent micro LEDs formed by performing a mesa etching process on an epitaxial structure formed on a wafer. The plurality of micro LEDs independently separated from each other by the mesa etching process may become completely independent as being separated from the wafer through, for example, a laser lift-off (LLO) process. The micro LED may have one surface which is a light-emitting surface (for example, a surface where light is finally emitted from the micro LED), and the other surface which is a surface opposite to the light-emitting surface and on which a pair of (LED) electrodes are disposed. The micro LED may have a plurality of sidewalls, formed during the etching process, between the light-emitting surface and the surface on which the pair of (LED) electrodes are positioned.

In the present disclosure, the micro LED may have improved luminous efficiency and thermal stability by including a current guiding part controlling a current path, through which a current applied to the electrode flows toward a current active layer, to be as far away as possible from a side surface of the micro LED. Here, the current guiding part may have an insulating property by chemically changing a periphery of a semiconductor layer. The current path may lead to a current spreading layer through a remaining portion of the semiconductor layer, (e.g., central part of the semiconductor layer) that is not changed to the current guiding part. When passing through the central part of the semiconductor layer, the current may flow as far away as possible from the sidewall of the micro LED by the current guiding part, and proceed to the current spreading layer through the active layer.

In the present disclosure, the display module may have a black matrix formed between the plurality of micro LEDs arranged on the TFT layer. The black matrix may improve a contrast ratio of the display module by preventing leakage of light from peripheries of the micro LEDs adjacent to each other.

In the present disclosure, the display module may further include a touch screen panel disposed on a side thereof where the plurality of micro LEDs emit light, and in this case, may include a touch screen driver for driving the touch screen panel.

In the present disclosure, the display module may further include a rear substrate disposed on the rear surface of the glass substrate and in electrical connection through a flexible printed circuit (FPC) or the like, and the display module may further include a communication device which may receive data.

In the present disclosure, the display module may refer to the glass substrate on which the micro LED is mounted and the side wiring is positioned. The display module may be installed and applied in an electronic product or electric field that requires a wearable device, a portable device, a handheld device, or any of various displays as a single unit, and applied to a display device such as a monitor for a personal computer (PC), a high-resolution television (TV), a signage (or digital signage) or an electronic display when the plurality of display modules are assembled and arranged in a matrix type.

Hereinafter, the display module according to an embodiment of the present disclosure is described with reference to the drawings.

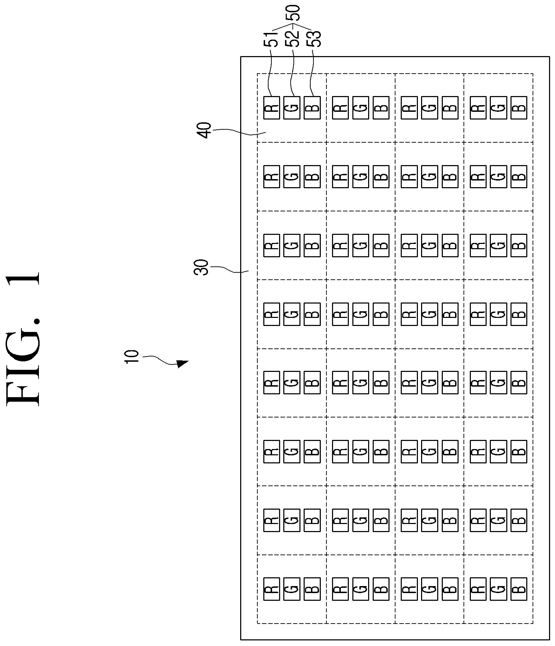

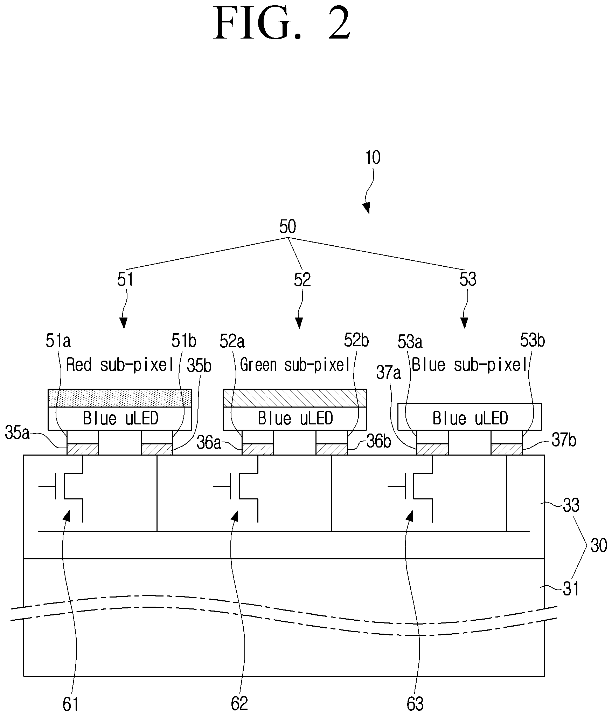

FIG. 1 is a plan view showing a display module including a plurality of pixels each having a red/green/blue (R/G/B) sub-pixel according to an embodiment of the present disclosure; and FIG. 2 is a schematic view showing a side surface of the pixel included in the display module according to an embodiment of the present disclosure.

Referring to FIG. 1, a display module 10 may include a TFT substrate 30, a panel driver (not shown), and a processor (not shown).

Referring to FIG. 2, the TFT substrate 30 may include a glass substrate 31 and a TFT layer 33 positioned on a front surface of the glass substrate 31. The TFT layer 33 may include a plurality of pixel areas 40. Each pixel area 40 may include a plurality of sub-pixels and a plurality of pixel circuits for driving each sub-pixel. The plurality of sub-pixels and the plurality of pixel circuits, disposed in each pixel area 40, are described in detail below.

Gate lines and data lines may cross each other in the TFT substrate 30, and a pixel circuit may be positioned in an area provided at this intersection.

The panel driver may drive the plurality of pixel circuits of the TFT substrate 30 under control of the processor, and may include a timing controller, a data driver, and a gate driver.

The timing controller may receive an input signal, a horizontal synchronization signal, a vertical synchronization signal, a main clock signal, or the like from the outside, thus generate an image data signal, a scan control signal, a data control signal, a light-emission control signal, or the like, and provide the same to the TFT substrate 30, the data driver, the gate driver, or the like.

In particular, the timing controller may apply a control signal MUX Sel R, G, and B for selecting one of the red (R), green (G), and blue (B) sub-pixels to the driving circuit.

The data driver (or source driver) may be a device for generating a data signal, and receive image data including an R/G/B component from the processor to generate data voltage (e.g., pulse width modulation (PWM) data voltage or pulse amplitude modulation (PAM) data voltage). In addition, the data driver may apply the generated data signal to the TFT substrate 30.

The gate driver may be a device for generating various control signals such as a control signal of synchronized pulsewidth modulation (SPWM(n)) and a control signal of synchronized pulse-amplitude modulation (SPAM), and transmit the generated various control signals to the specific row (or the specific horizontal line) or all lines of the TFT substrate 30. In addition, the gate driver may apply a driving voltage (i.e., Voltage Drain (VDD)) to a driving voltage terminal of the driving circuit according to an embodiment.

Meanwhile, all or part of the data driver or the gate driver may be implemented in the TFT layer 33, or implemented as a separate semiconductor integrated circuit (IC) and disposed on the rear surface of the glass substrate 31.

The processor may control overall operations of the display module 10. In particular, the processor may control the panel driver to drive the TFT substrate 30 so that the plurality of pixel circuits perform the above-described operations.

To this end, the processor may be implemented as one or more of a central processing unit (CPU), a micro-controller, an application processor (AP), a communication processor (CP), or an advanced RISC machine (ARM) processor. According to an embodiment of the present disclosure, the processor may control the panel driver to set a pulse width of a driving current based on the PWM data voltage and set pulse amplitude of the driving current based on the PAM data voltage. Here, the TFT substrate 30 may include n-th rows and m-th columns. In this case, the processor may control the panel driver to apply the PWM data voltage in row units (i.e., horizontal line units). In addition, the processor may control the panel driver to apply the PAM data voltage to all the sub-pixels of the TFT layer 33 at once. The processor may then control the panel driver to apply the driving voltage (VDD) to the plurality of pixel circuits included in the TFT layer 33 at once, and apply a linear change voltage (or a sweep voltage) to the PWM driving circuit of each of the plurality of pixel circuits so that the image is displayed.

Although the present disclosure describes the processor and the timing controller as separate components, the timing controller may perform functions of the processor without the processor in some embodiments.

Referring to FIG. 2, a plurality of sub-pixels 51, 52, and 53 and a plurality of pixel circuits 61, 62, and 63 may be arranged in each pixel area 40 provided in the TFT layer 33.

The TFT layer 33 may be positioned on the front surface of the glass substrate 31 and have a multilayer structure. For example, the TFT layer 33 may include a buffer layer stacked on the front surface of the glass substrate 31, a gate insulating layer stacked on the buffer layer, an interlayer insulating layer stacked on the gate insulating layer, and a plurality of passivation layers sequentially stacked on the interlayer insulating layer. The TFT layer 33 may further include wiring electrically connected to the voltage (i.e., VDD and VSS) terminals.

In the present disclosure, one pixel may include three sub-pixels 51, 52, and 53. Each sub-pixel may be a light emitting device, for example, the micro LED. In the present disclosure, the 'sub-pixel' may be used interchangeably with the 'micro LED'.

The present disclosure describes that the plurality of sub-pixels each include three micro LEDs corresponding to red/green/blue (R/G/B) colors for example. However, the present disclosure is not necessarily limited thereto. That is, the plurality of sub-pixels may be two micro LEDs of red/blue (R/B), red/green (R/G) or green/blue (G/B), three micro LEDs of red/blue/white (R/B/W), four micro LEDs of red/green/blue/white (R/G/B/W), red/green/green/white (R/G/G/W) or red/green/blue/yellow (R/G/B/Y), or five micro LEDs of red/green/blue/yellow/cyan (R/G/B/Y/C). In this case, the number of pixel circuits may correspond to the number of sub-pixels.

The plurality of sub-pixels 51, 52, and 53 may respectively include first electrodes (anode electrodes) 51a, 52a, and 53a, and second electrodes (cathode electrodes) 51b, 52b, and 53b.

The first electrodes 51a, 52a, and 53a of each sub-pixel may be electrically connected to first TFT electrodes 35a, 36a, and 37a, respectively, and connected to the driving voltage (VDD) through the first TFT electrodes 35a, 36a and 37a, respectively. On the other hand, the second electrodes 51b, 52b, and 53b of each sub-pixel may be electrically connected to second TFT electrodes 35b, 36b, and 37b, respectively, and connected to a ground voltage (voltage source supply (VSS)) terminal through the second TFT electrodes 35b, 36b, and 37b.

The plurality of pixel circuits 61, 62, and 63 may be electrically connected to the sub-pixels 51, 52, and 53, respectively, and control to turn on or blink the corresponding sub-pixels 51, 52, and 53, respectively.

The R/G/B sub-pixels 51, 52, and 53 shown in FIG. 2 may be configured as follows, for example. The red sub-pixel 51 may include a blue micro LED and a red wavelength conversion layer stacked on a light-emitting surface of the blue micro LED. The green sub-pixel 52 may include a blue micro LED and a green wavelength conversion layer stacked on a light-emitting surface of the blue micro LED. The blue sub-pixel 53 may only include a blue micro LED.

Hereinafter, the description sequentially describes structures of various micro LEDs and their manufacturing processes according to the present disclosure.

The present disclosure describes a horizontal type flip-chip micro LED for example. However, the present disclosure is not limited thereto and may take a vertical type micro LED (not shown).

The micro LED of the present disclosure may have a maximum lateral length L1 of, for example, 60 um or less.

The micro LED of the present disclosure may have a stacked structure of an n-type semiconductor layer, an active layer (light emitting layer), and a p-type semiconductor layer.

The micro LED of the present disclosure may include a current guiding part guiding the current path to be spaced apart as far as possible from a predetermined portion (for example, the side surface of the micro LED).

In addition, the micro LED of the present disclosure does not require a separate current spreading layer between the current guiding part and a second cladding layer.

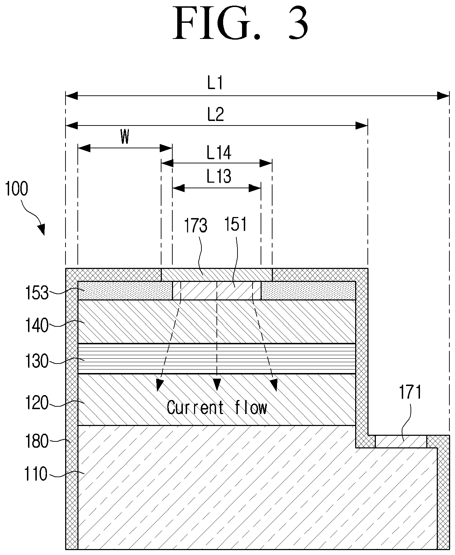

FIG. 3 is a schematic view showing the micro light emitting diode (LED) according to an embodiment of the present disclosure.

Referring to FIG. 3, a micro LED 100 may include a current spreading layer 110, a first cladding layer 120, an active layer 130, a second cladding layer 140, a semiconductor layer 151 through which the current passes, a current guiding part 153 for controlling the current path to guide the current to flow through the semiconductor layer 151, a first electrode 171 positioned on the current spreading layer 110, a second electrode 173 positioned on the semiconductor layer 151, and a passivation layer 180.

The current spreading layer 110 may be a layer grown in an epitaxial process, and serving as a growth base of the first cladding layer 120.

The first cladding layer 120 may be a conductivity type semiconductor layer, and may be the n-type (or p-type) semiconductor layer. The second cladding layer 140 may be the conductivity type semiconductor layer, and may be the p-type (or n-type) semiconductor layer.

The second cladding layer 140 may be the p-type semiconductor layer when the first cladding layer 120 is the n-type semiconductor layer. On the other hand, the second cladding layer 140 may be the n-type semiconductor layer when the first cladding layer 120 is the p-type semiconductor layer.

The first and second cladding layers 120 and 140 may each be a semiconductor having a band gap corresponding to a specific area of a spectrum. For example, the first and second cladding layers 120 and 140 may include one or more AlInGaP-based semiconductor layers included in the red micro LED having an emission wavelength of 600 to 750 nm, and one or more AlInGaP-based semiconductor layers included in the blue or green micro LED having an emission wavelength of 450 to 490 nm or 500 to 570 nm, respectively.

Each maximum lateral length L12 of the first and second cladding layers 120 and 140 may be smaller than a maximum lateral length L11 of the micro LED 100.

A carrier concentration of the first cladding layer 120 may be less than $5E+17/cm^3$.

A carrier concentration of the second cladding layer 140 may be preferably less than $5E+17/cm^3$. The carrier concentration of the second cladding layer 140 may prevent a current spreading distance from being increased in the second cladding layer 140, thereby preventing the current from being spread to the side surface of the micro LED, and also prevent an increase in a resistance of the second cladding layer 140, thereby maintaining a smooth current flow. A thickness of the second cladding layer 140 may be 350 nm or less.

The current spreading layer 110 and the first cladding layer 120 may be different from each other in their carrier concentration and band gap. For example, the carrier concentration of the current spreading layer 110 may be more than $1E+18/cm^3$. Accordingly, a resistance of the first cladding layer 120 may be higher than a resistance of the current spreading layer 110.

The current spreading layer 110 may have the optical band gap larger than that of the first cladding layer 120. For example, the current spreading layer 110 may have the band gap larger by 50 meV than that of the cladding layer.

The active layer 130 may be disposed between the first and second cladding layers 120 and 140, and include a so-called multiple-quantum-well (MQW) or a single-quantum-well (SQW).

The semiconductor layer 151 may be positioned on the second cladding layer 140, and have a maximum lateral length L13 smaller than the maximum lateral length L12 of the second cladding layer 140.

The semiconductor layer 151 may have a carrier concentration of less than $1E+18/cm^3$ and a thickness in a range of 10 to 500 nm. The semiconductor layer 151 may be the same type of semiconductor as the second cladding layer 140. For example, the semiconductor layer 151 may also be the p-type semiconductor when the second cladding layer 140 is the p-type semiconductor.

The current guiding part 153 may be positioned in an outer area of the semiconductor layer 151 and control a flow of the current flowing to the current spreading layer 110 through the semiconductor layer 151. For example, the current guiding part 153 may separate the current path from the side surface of the micro LED as far as possible.

The current guiding part 153 may be the same semiconductor layer as the semiconductor layer 151, and stacked on the second cladding layer 140, and ions (e.g., hydrogen (H), helium (He), carbon (C), iron (Fe), aluminum (Al), boron (B) and nitrogen (N)) may be implanted into the outer area of the semiconductor layer 151 to form a highly resistive area. In this case, an ion implantation width W may be about 5 um or more from the side surface of the micro LED 100 formed by the mesa etching toward the semiconductor layer 151.

The first electrode 171 may be electrically connected to the current spreading layer 110, and made of any one of aluminum (Al), titanium (Ti), chromium (Cr), nickel (Ni), palladium (Pd), silver (Ag), germanium (Ge), gold (Au), or an alloy thereof.

The second electrode 173 may be electrically connected to the semiconductor layer 151, and made of any one of aluminum (Al), titanium (Ti), chromium (Cr), nickel (Ni), palladium (Pd), silver (Ag), germanium (Ge), gold (Au), or an alloy thereof. A maximum lateral length L14 of the second electrode 173 may be greater than the maximum lateral length L13 of the semiconductor layer 131. Accordingly, the second electrode 173 may completely cover the semiconductor layer 131, and an edge of the second electrode 173 may cover a portion of the current guiding part 153.

A semiconductor contact layer (not shown) highly-doped to be very thin, for example, less than 10 nm may be positioned between the first electrode 171 and the current spreading layer 110, and between the second electrode 173 and the semiconductor layer 151, for their ohmic contacts. The semiconductor contact layer may use an electrically conductive oxide such as indium tin oxide (ITO) or zinc oxide (ZnO).

Hereinafter, the description describes a manufacturing process of the micro LED according to an embodiment of the present disclosure with reference to the drawings.

In the present disclosure, the epitaxial structure may be formed on the wafer, and the mesa etching process may then be performed on the epitaxial structure to form the plurality of independent micro LEDs. The independent plurality of micro LEDs may become completely independent from each other as being separated from the wafer through a next process, for example, the laser lift-off (LLO) process. Hereinafter, the description describes one micro LED among the plurality of micro LEDs as a reference.

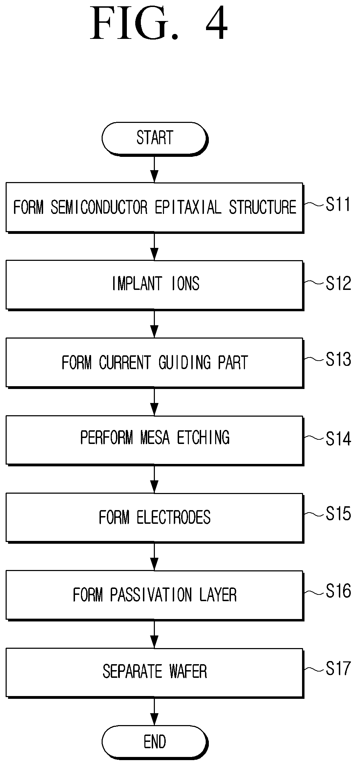

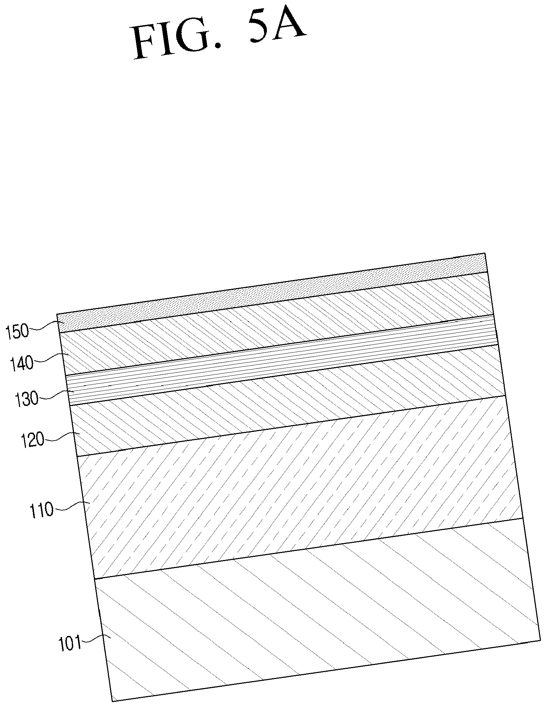

FIG. 4 is a flowchart showing the manufacturing process of the micro LED according to an embodiment of the present disclosure; and FIGS. 5A to 5F are process views sequentially showing the manufacturing process of the micro LED according to an embodiment of the present disclosure.

Referring to FIG. 5A, the epitaxial process may be performed on a wafer 101 to form the semiconductor epitaxial structure in which the current spreading layer 110, the first cladding layer 120, the active layer 130, the second cladding layer 140, and the semiconductor layer 150 are sequentially stacked (S11).

The semiconductor epitaxial structure may be formed by the epitaxial growth technique such as metalorganic vapor phase epitaxy (MOVPE), molecular beam epitaxy (MBE), or sputtering.

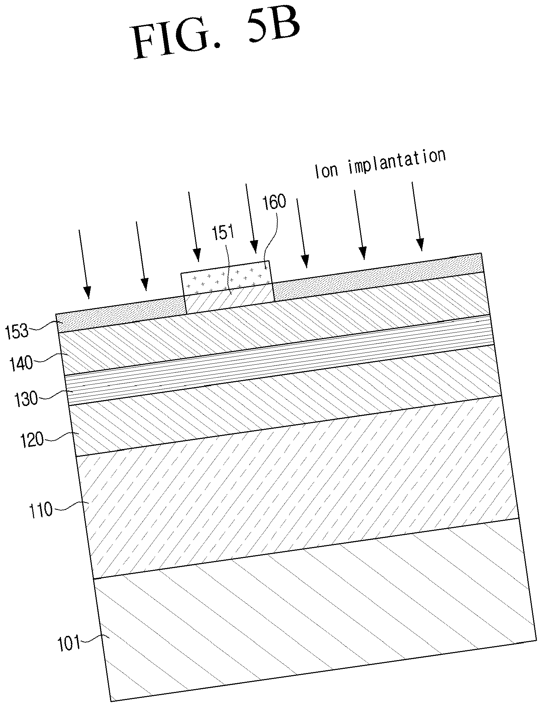

Referring to FIG. 5B, the ions may be implanted into the outer area of the semiconductor layer 150 (S12).

In this case, a surface of the semiconductor layer 150 may be patterned by a resist mask 160 defining an ion implantation area.

An ion implantation depth may be defined by an accelerating voltage of ion species during the ion implantation. It is preferable that the ion implantation depth does not deviate from the semiconductor layer 150. For example, as ions which may form a highly resistive semiconductor layer, hydrogen (H), helium (He), and iron (Fe) may be used for an AlGaInP-based red micro-LED, and boron (B), aluminum (Al), iron (Fe), carbon (C), and nitrogen (N) may be used for GaN-based blue and green micro LEDs.

The current guiding part 153 may be formed on the second cladding layer 140 which may control the current path by completing an ion implantation process in the outer area of the semiconductor layer 150 (S13).

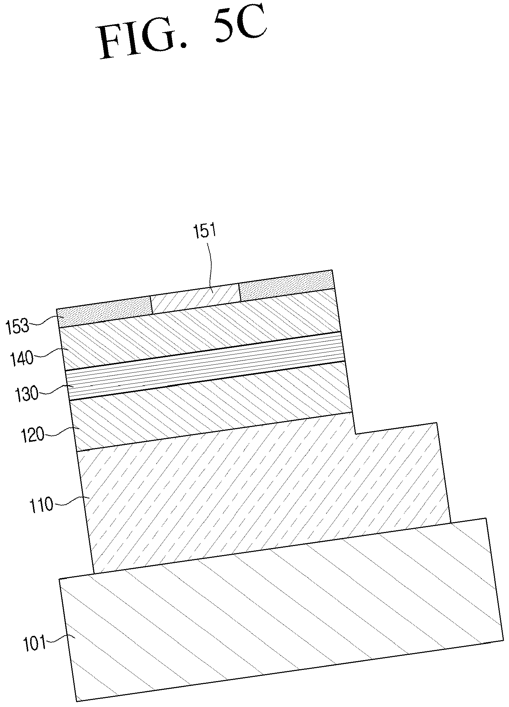

Referring to FIG. 5C, the mesa etching process may be performed on the semiconductor epitaxial structure (S14).

The mesa etching process may be performed by, for example, a photolithography process or a dry etching process. The independent plurality of micro LEDs may be formed by performing the mesa etching process on the semiconductor epitaxial structure. In this case, each micro LED may have a side surface through the mesa etching process.

Accordingly, the semiconductor epitaxial structure including the current guiding part 153 may include the plurality of independent ultraviolet (UV) micro LEDs arranged at a predetermined distance from each other.

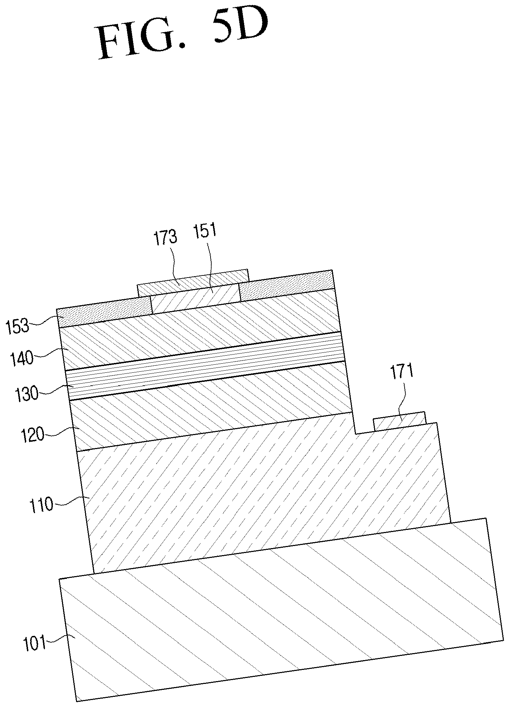

Referring to FIG. 5D, the first electrode 171 may be formed on the current spreading layer 110, and the second electrode 173 may be formed on the semiconductor layer 151 (S15) .

The first and second electrodes 171 and 173 may be formed by, for example, the lift-off process.

Although not shown in the drawings, the semiconductor contact layer (not shown) may be positioned between the first electrode 171 and the current spreading layer 110, and between the second electrode 173 and the semiconductor layer 151, for their ohmic contacts. The semiconductor contact layer may be deposited on each of the current spreading layer 110 and the semiconductor layer 151 by any of various techniques such as sputtering, evaporation, and spin coating.

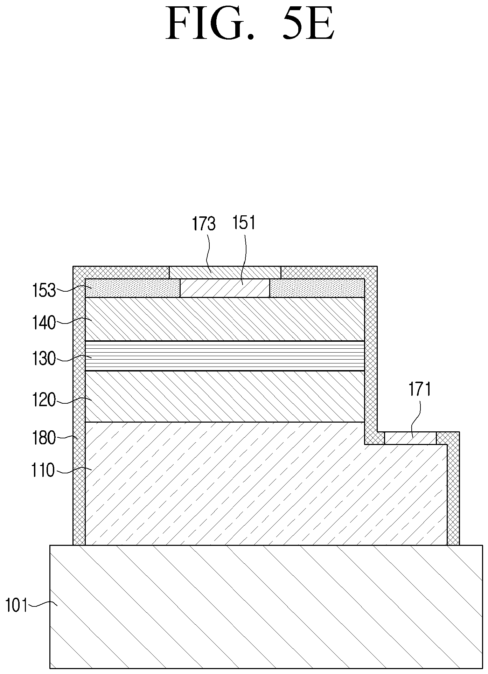

Referring to FIG. 5E, the passivation layer 180 may be formed on a surface of the UV micro LED (S16).

In this case, the passivation layer 180 may not cover the first electrode 171 or the second electrode 173 when stacked on the surface of the UV micro LED.

The passivation layer 180 may be made of a material such as alumina ($Al_2O_3$), silica ($SiO_2$), or silicon nitride (SiN). The passivation layer may be formed by any of various techniques such as atomic layer deposition, e-beam evaporation, sputtering, chemical vapor deposition, and spin coating.

Although not shown in the drawings, the passivation layer 180 may be formed, and a mirror layer such as a Distributed Bragg Reflector (DBR) may then be stacked on the passivation layer to improve light extraction efficiency of the micro LED.

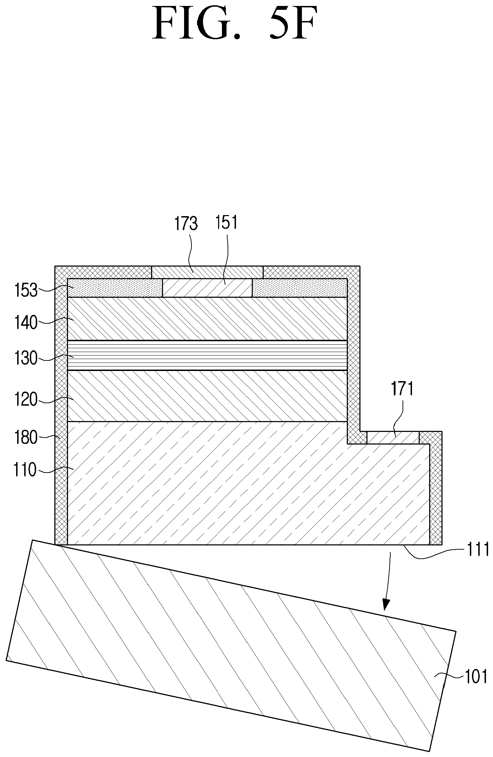

Referring to FIG. 5F, the plurality of micro LEDs 100 may be separated from the wafer 101 by irradiating a laser beam to a rear surface of the wafer 101 (S17).

Although not shown in the drawings, a carrier substrate (not shown) may be moved toward the wafer 101 to attach one surface of the carrier substrate to the plurality of micro LEDs 100 before the plurality of micro LEDs 100 formed on the wafer 101 is separated from the wafer 101. Here, the carrier substrate may be a substrate for transferring the plurality of micro LEDs 100 to be separated from the wafer 101 to the TFT substrate 30 (see FIG. 2).

The plurality of micro LEDs 100 may be supported by the carrier substrate having an adhesive layer (not shown) on its surface while being separated from the wafer 101. The adhesive layer may be referred to as a Dynamic Release Layer (DRL), and may be made of a material (e.g., polyimide) which may be easily separated from the carrier substrate when the micro LEDs 100 are transferred to the TFT layer 33 (see FIG. 2) of the TFT substrate 30 by using a laser transfer method. The laser transfer method may refer to a method in which the carrier substrate is positioned on an upper surface of the TFT substrate 30 at a predetermined distance, for example, and the carrier substrate is then irradiated with the laser beam to thus heat a portion of the adhesive layer to which the micro LEDs 100 are fixed, thereby separating the micro LEDs 100 from the carrier substrate and transferring the same to the TFT substrate 30.

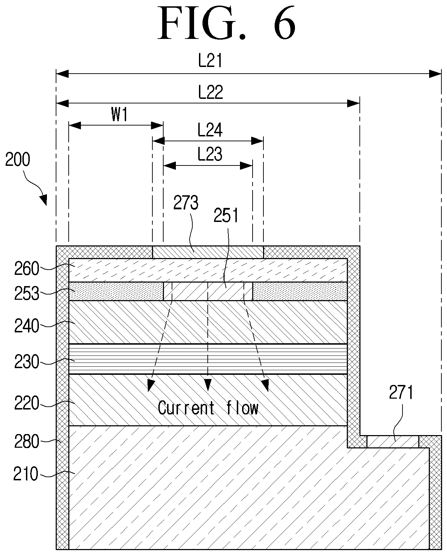

FIG. 6 is a schematic view showing a micro LED according to another embodiment of the present disclosure.

Referring to FIG. 6, a micro light emitting diode (LED) 200 may include a current spreading layer 210, a first cladding layer 220, an active layer 230, a second cladding layer 240, a second cladding layer 240, a first semiconductor layer 251 and a current guiding part 253, formed on the second cladding layer 240, a second semiconductor layer 260, formed on the first semiconductor layer 251 and the current guiding part 253, a first electrode 271 formed on the current spreading layer 210, a second electrode 273 formed on the second semiconductor layer 260, and a passivation layer 280.

The current spreading layer 210 may be a layer grown in an epitaxial process, and serving as a growth base of the first cladding layer 220.

The first cladding layer 220 may be a conductivity type semiconductor layer, and may be an n-type (or p-type) semiconductor layer. The second cladding layer 240 may be the conductivity type semiconductor layer, and may be the p-type (or n-type) semiconductor layer.

The second cladding layer 240 may be the p-type semiconductor layer when the first cladding layer 220 is the n-type semiconductor layer. On the other hand, the second cladding layer 240 may be the n-type semiconductor layer when the first cladding layer 220 is the p-type semiconductor layer.

The first and second cladding layers 220 and 240 may be semiconductors each having a band gap corresponding to a specific area of a spectrum. For example, the first and second cladding layers 220 and 240 may include one or more AlInGaP-based semiconductor layers included in a red micro LED having an emission wavelength of 600 to 750 nm, and one or more AlInGaP-based semiconductor layers included in a blue or green micro LED having an emission wavelength of 450 to 490 nm or 500 to 570 nm, respectively.

Each maximum lateral length L22 of the first and second cladding layers 220 and 240 may be smaller than a maximum lateral length L21 of the micro LED 100.

The current spreading layer 210 and the first cladding layer 220 may be different from each other in their carrier concentration and band gap. For example, the carrier concentration of the current spreading layer 210 may be more than $1E+18/cm^3$, whereas the carrier concentration of the first cladding layer 220 may be less than $5E+17/cm^3$. That is, a resistance of the first cladding layer 220 may be higher than a resistance of the current spreading layer 210.

The current spreading layer 210 may have the optical band gap larger than that of the first cladding layer 220. For example, the current spreading layer 210 may have the band gap larger by 50 meV than that of the cladding layer.

The active layer 230 may be positioned between the first and second cladding layers 220 and 240, and include a so-called multiple-quantum-well (MQW) or a single-quantum-well (SQW).

A carrier concentration of the second cladding layer 240 may be preferably less than $5E+17/cm^3$. The carrier concentration of the second cladding layer 240 may prevent a current spreading distance from being increased in the second cladding layer 240, thereby preventing a current from being spread to a side surface of the micro LED, and also prevent an increase in the resistance of the second cladding layer 240, thereby maintaining a smooth current flow.

The first semiconductor layer 251 may be positioned on the second cladding layer 240, and have a maximum lateral length L23 smaller than the maximum lateral length L22 of the second cladding layer 240.

The first semiconductor layer 251 may be made of the same AlAs-based and GaP-based semiconductor materials as the second cladding layer 240 together with the second semiconductor layer 260 described below. In addition, like the second cladding layer 240, the first semiconductor layer 251 may have a carrier concentration of less than $1E+18/cm^3$ and a thickness in a range of 10 to 500 nm.

The first semiconductor layer 251 and the second semiconductor layer 260 may be the same type of semiconductors as the second cladding layer 240. For example, the first semiconductor layer 251 may also be the p-type semiconductors when the second semiconductor layer 260 is the p-type semiconductor.

The current guiding part 253 may be positioned in an outer area of the first semiconductor layer 251 and control a flow of the current flowing to the current spreading layer 210 through the first semiconductor layer 251. For example, the current guiding part 253 may separate a current path from the side surface of the micro LED as far as possible.

The current guiding part 253 may be the same semiconductor layer as the first semiconductor layer 251, and stacked on the second cladding layer 240, and ions (e.g., hydrogen (H), helium (He), carbon (C), iron (Fe), aluminum (Al), Boron (B) and nitrogen (N)) may be implanted into the outer area of the first semiconductor layer 251 to form a highly resistive area. In this case, an ion implantation width W may be about 5 um or more from the side surface of the micro LED 200 formed by mesa etching toward the first semiconductor layer 251.

The second semiconductor layer 260 may be formed on the first semiconductor layer 251 and the current guiding part 253. The second semiconductor layer 260 may be made of the same material as those of the first semiconductor layer 251 and the second cladding layer 240 as described above.

A carrier concentration of the second semiconductor layer 260 may be greater than or equal to the carrier concentration of the second cladding layer 240. Accordingly, the current passing through the second semiconductor layer 260 may smoothly flow to the second cladding layer 240 through the first semiconductor layer 251.

A maximum lateral length of the second semiconductor layer 260 may be the same as the maximum lateral length L22 of the first cladding layer 220 or the second cladding layer 240.

The first electrode 271 may be electrically connected to the current spreading layer 210, and made of any one of aluminum (Al), titanium (Ti), chromium (Cr), nickel (Ni), palladium (Pd), silver (Ag), germanium (Ge), gold (Au), or an alloy thereof.

The second electrode 273 may be electrically connected to the second semiconductor layer 260, and made of any one of aluminum (Al), titanium (Ti), chromium (Cr), nickel (Ni), palladium (Pd), silver (Ag), germanium (Ge), gold (Au), or an alloy thereof. A maximum lateral length L24 of the second electrode 273 may be greater than the maximum lateral length L22 of the second semiconductor layer 260. Accordingly, the second electrode 173 may completely cover the first semiconductor layer 251, and an edge of the second electrode 273 may cover a portion of the current guiding part 253, when the micro LED 200 of FIG. 6 is viewed from above. In this case, the second electrode 273 may not be in direct contact with the first semiconductor layer 251 or the current guiding part 253.

A semiconductor contact layer (not shown) highly-doped to be very thin, for example, less than 10 nm may be positioned between the first electrode 271 and the current spreading layer 210, and between the second electrode 273 and the second semiconductor layer 260, for their ohmic contacts. The semiconductor contact layer may use an electrically conductive oxide such as indium tin oxide (ITO) or zinc oxide (ZnO).

Hereinafter, the description describes a manufacturing process of the micro LED according to another embodiment of the present disclosure with reference to the drawings.

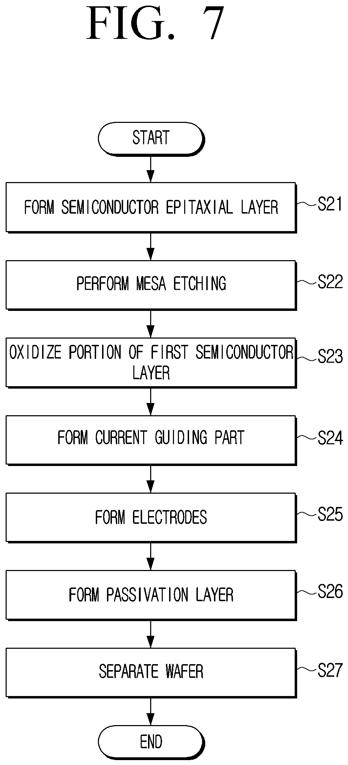

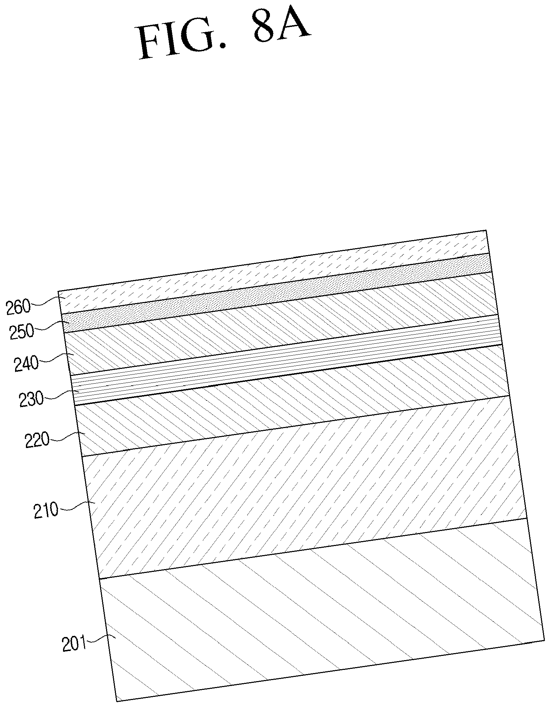

FIG. 7 is a flowchart showing the manufacturing process of the micro LED according to another embodiment of the present disclosure; and FIGS. 8A to 8F are process views sequentially showing the manufacturing process of the micro LED according to another embodiment of the present disclosure.

Referring to FIG. 8A, the epitaxial process may be performed on a wafer 201 to form a semiconductor epitaxial structure in which the current spreading layer 210, the first cladding layer 220, the active layer 230, the second cladding layer 240, a first semiconductor layer 250, and the second semiconductor layer 260 are sequentially stacked (S21).

The semiconductor epitaxial structure may be formed by an epitaxial growth technique such as metalorganic vapor phase epitaxy (MOVPE), molecular beam epitaxy (MBE), or sputtering.

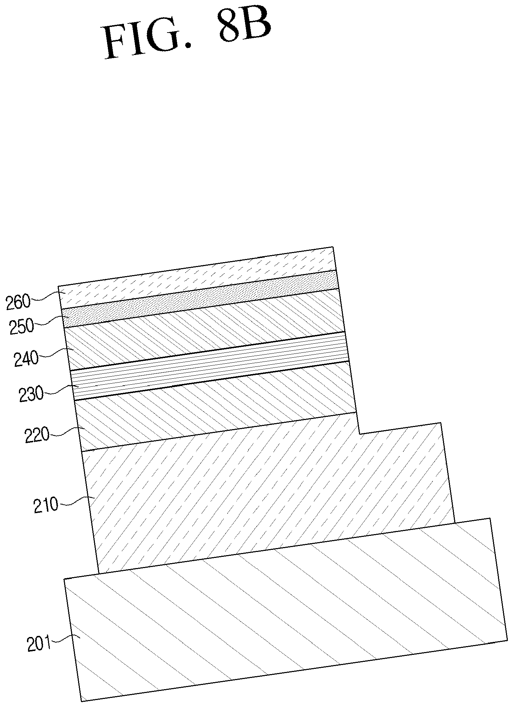

Referring to FIG. 8B, the mesa etching process may be performed on the semiconductor epitaxial structure (S22).

The mesa etching process may refer to a process of processing from the second cladding layer 240 to the current spreading layer 210 to manufacture a flip chip, and may be performed by, for example, a photolithography process or a dry etching process.

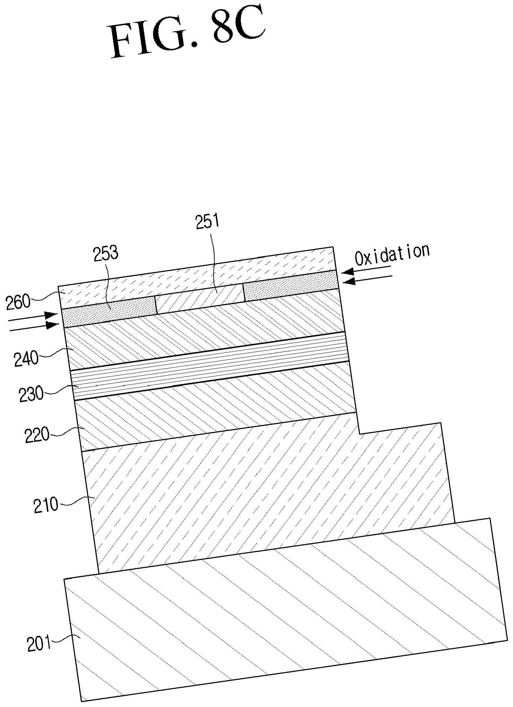

Referring to FIG. 8C, an outer area of the first semiconductor layer 250 may be oxidized (S23).

In this case, an upper surface of the first semiconductor layer 250 may be covered by the second semiconductor layer 260. Accordingly, the oxidation of the AlAs-based first semiconductor layer 250 may start from a mesa-etched side surface area. A size of the oxidized area may be controlled by annealing conditions such as temperature, duration, and partial pressure of water ($H_2O$).

The current guiding part 253 may be formed when partial oxidation of the AlAs-based first semiconductor layer 250 is completed by $H_2O$ oxidation or other suitable technique (S24) .

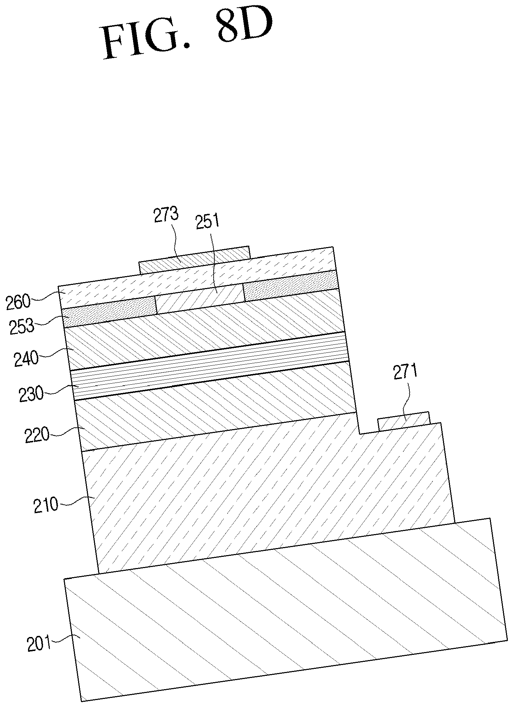

Referring to FIG. 8D, the first electrode 271 may be formed on the current spreading layer 210, and the second electrode 273 may be formed on the second semiconductor layer 260 (S25).

The first electrode 271 and the second electrode 273 may be formed by, for example, a laser lift-off process.

Although not shown in the drawings, the semiconductor contact layer (not shown) may be positioned between the first electrode 271 and the current spreading layer 210, and between the second electrode 273 and the second semiconductor layer 260, for their ohmic contacts. The semiconductor contact layer may be deposited on each of the current spreading layer 210 and the second semiconductor layer 260 by any of various techniques such as sputtering, evaporation, and spin coating.

The plurality of ultraviolet (UV) micro LEDs may be formed on the wafer 201 through this process.

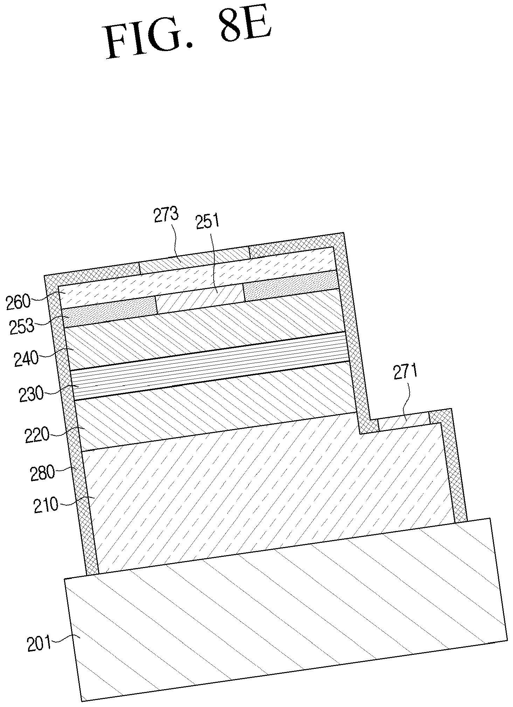

Referring to FIG. 8E, the passivation layer 280 may be formed on a surface of the UV micro LED (S26).

In this case, the passivation layer 280 may not cover the first electrode 271 or the second electrode 273 when stacked on the surface of the UV micro LED.

The passivation layer 280 may be made of a material such as alumina ($Al_2O_3$), silica ($SiO_2$), or silicon nitride (SiN). The passivation layer may be formed by any of various techniques such as atomic layer deposition, e-beam evaporation, sputtering, chemical vapor deposition, and spin coating.

Although not shown in the drawings, the passivation layer 280 may be formed, and a mirror layer such as a Distributed Bragg Reflector (DBR) may then be stacked on the passivation layer to improve light extraction efficiency of the micro LED.

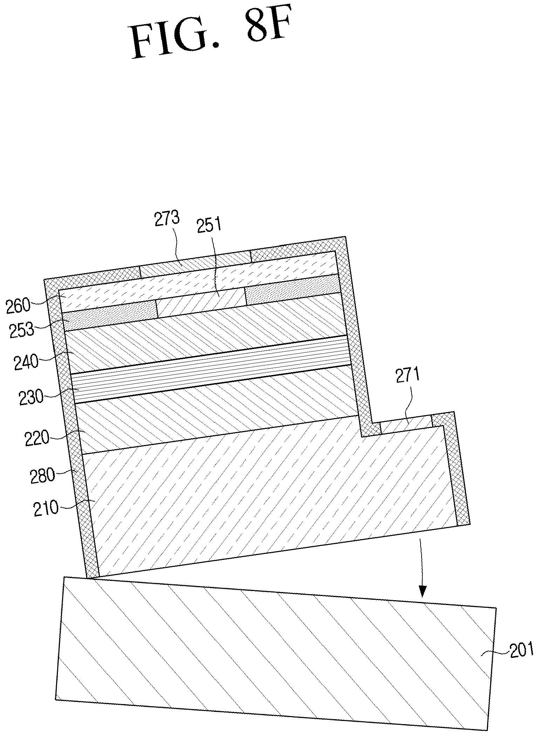

Referring to FIG. 8F, the plurality of micro LEDs 200 may be separated from the wafer 201 by irradiating a laser beam to a rear surface of the wafer 201 (S27).

The plurality of micro LEDs 200 formed on the wafer 201 may be attached to one surface of a carrier substrate (not shown) before being separated from the wafer 201.

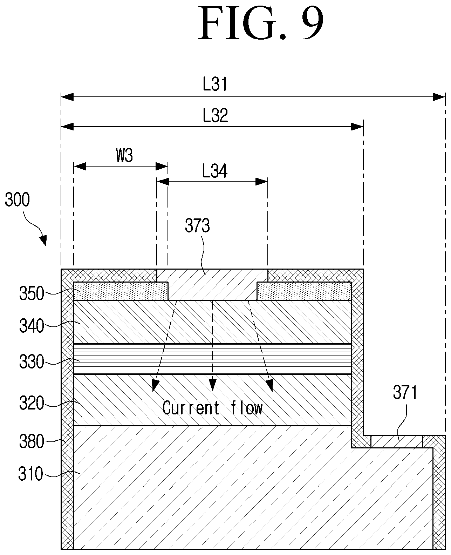

FIG. 9 is a schematic view showing a micro LED according to still another embodiment of the present disclosure.

Referring to FIG. 9, a micro light emitting diode (LED) 300 may include a current spreading layer 310, a first cladding layer 320, an active layer 330, a second cladding layer 340, a current guiding part 350 formed on the second cladding layer 340, a first electrode 371 formed on the current spreading layer 310, a second electrode 373 formed on the second cladding layer 340, and a passivation layer 380.

The current spreading layer 310 may be a layer grown in an epitaxial process, and serving as a growth base of the first cladding layer 320.

The first cladding layer 320 may be a conductivity type semiconductor layer, and may be an n-type (or p-type) semiconductor layer. The second cladding layer 340 may be the conductivity type semiconductor layer, and may be the p-type (or n-type) semiconductor layer.

The second cladding layer 340 may be the p-type semiconductor layer when the first cladding layer 320 is the n-type semiconductor layer. On the other hand, the second cladding layer 340 may be the n-type semiconductor layer when the first cladding layer 320 is the p-type semiconductor layer.

The first cladding layer 320 and the second cladding layer 340 may be semiconductors each having a band gap corresponding to a specific area of a spectrum. For example, the first cladding layer 320 and the second cladding layer 340 may include one or more AlInGaP-based semiconductor layers included in a red micro LED having an emission wavelength of 600 to 750 nm, and one or more AlInGaP-based semiconductor layers included in a blue or green micro LED having an emission wavelength of 450 to 490 nm or 500 to 570 nm, respectively.

Each maximum lateral length L32 of the first cladding layer 320 and the second cladding layer 340 may be smaller than a maximum lateral length L31 of the micro LED 300.

The current spreading layer 310 and the first cladding layer 320 may be different from each other in their carrier concentration and band gap. For example, the carrier concentration of the current spreading layer 310 may be more than $1E+18/cm^3$, whereas the carrier concentration of the first cladding layer 320 may be less than $5E+17/cm^3$. That is, a resistance of the first cladding layer 320 may be higher than a resistance of the current spreading layer 310.

The current spreading layer 310 may have the optical band gap larger than that of the first cladding layer 320. For example, the current spreading layer 310 may have the band gap larger by 50 meV than that of the cladding layer.

A carrier concentration of the second cladding layer 340 may be preferably less than $5E+17/cm^3$. The carrier concentration of the second cladding layer 340 may prevent a current spreading distance from being increased in the second cladding layer 340, thereby preventing a current from being spread to a side surface of the micro LED, and also prevent an increase in the resistance of the second cladding layer 340, thereby maintaining a smooth current flow.

The active layer 330 may be positioned between the first cladding layer 320 and the second cladding layer 340, and include a so-called multiple-quantum-well (MQW) or a single-quantum-well (SQW).

The current guiding part 350 may be formed on the second cladding layer 340, and surround the outside of the second electrode 372 formed together on the second cladding layer 340.

The current guiding part 350 may be made of an insulating material such as silica ($SiO_2$), silicon nitride (SiN), or alumina ($Al_2O_3$). A maximum lateral length L34 of the second electrode may be 10 um or less, and in this case, the current guiding part 350 may have a width W3 of 5 um or more from an etched side surface of the micro LED toward the second electrode 373.

Accordingly, the current guiding part 350 may control a flow of current flowing to the current spreading layer 310 through the second electrode 373. For example, the current guiding part 350 may separate a current path from the side surface of the micro LED as far as possible.

The first electrode 371 may be electrically connected to the current spreading layer 310, and made of any one of aluminum (Al), titanium (Ti), chromium (Cr), nickel (Ni), palladium (Pd), silver (Ag), germanium (Ge), gold (Au), or an alloy thereof.

The second electrode 373 may be electrically connected to the second cladding layer 340, and made of any one of aluminum (Al), titanium (Ti), chromium (Cr), nickel (Ni), palladium (Pd), silver (Ag), germanium (Ge), gold (Au), or an alloy thereof. The second electrode 373 may have a lower portion disposed between the current guiding parts 350 and an upper portion disposed above the current guiding part 350. In this case, the maximum lateral length L34 of the upper portion of the second electrode 373 may be smaller than the maximum lateral length L32 of the second cladding layer 340. Accordingly, an edge of the upper portion of the second electrode 373 may cover a portion of the current guiding part 350.

A semiconductor contact layer (not shown) highly-doped to be very thin, for example, less than 10 nm may be positioned between the first electrode 371 and the current spreading layer 310, and between the second electrode 373 and the second cladding layer 340, for their ohmic contacts. The semiconductor contact layer may use an electrically conductive oxide such as indium tin oxide (ITO) or zinc oxide (ZnO).

Hereinafter, the description describes a manufacturing process of the micro LED according to still another embodiment of the present disclosure with reference to the drawings.

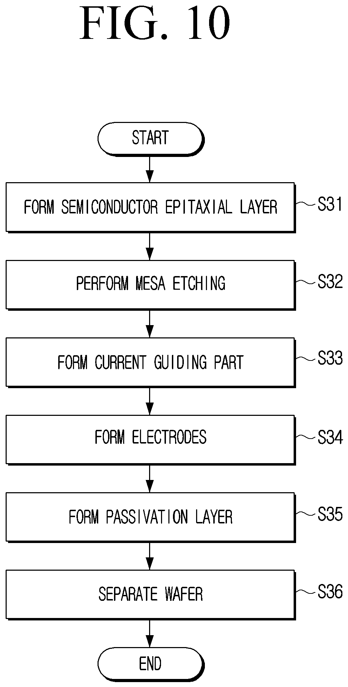

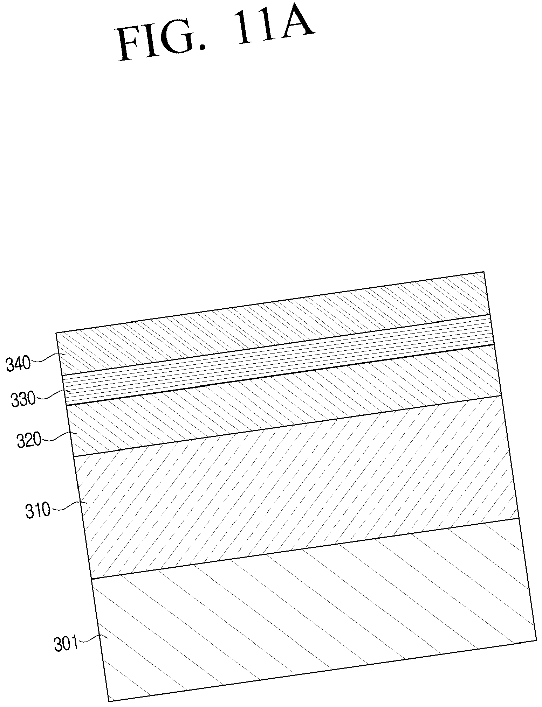

FIG. 10 is a flowchart showing the manufacturing process of the micro LED according to still another embodiment of the present disclosure; and FIGS. 11A to 11F are process views sequentially showing the manufacturing process of the micro LED according to still another embodiment of the present disclosure.

Referring to FIG. 11A, the epitaxial process may be performed on a wafer 301 to form a semiconductor epitaxial structure in which the current spreading layer 310, the first cladding layer 320, the active layer 330, and the second cladding layer 340 are sequentially stacked (S31).

The semiconductor epitaxial structure may be formed by an epitaxial growth technique such as metalorganic vapor phase epitaxy (MOVPE), molecular beam epitaxy (MBE), or sputtering.

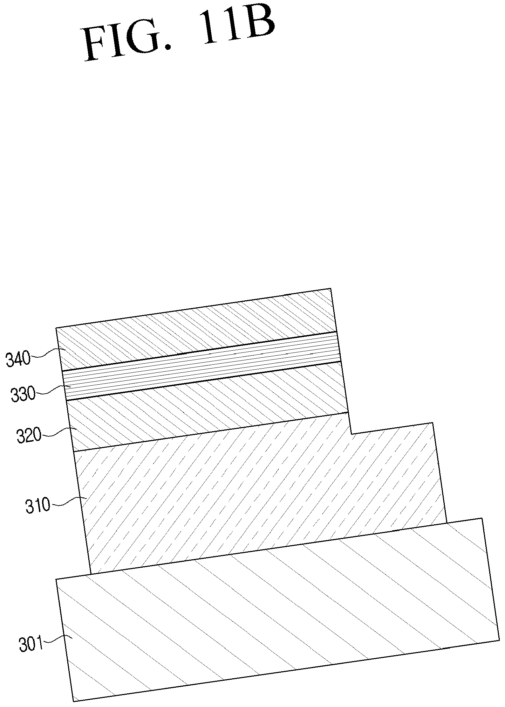

Referring to FIG. 11B, the mesa etching process may be performed on the semiconductor epitaxial structure (S32).

The mesa etching process may be performed by, for example, a photolithography process or a dry etching process. Accordingly, the semiconductor epitaxial structure may include the plurality of independent ultraviolet (UV) micro LEDs arranged at a predetermined distance from each other.

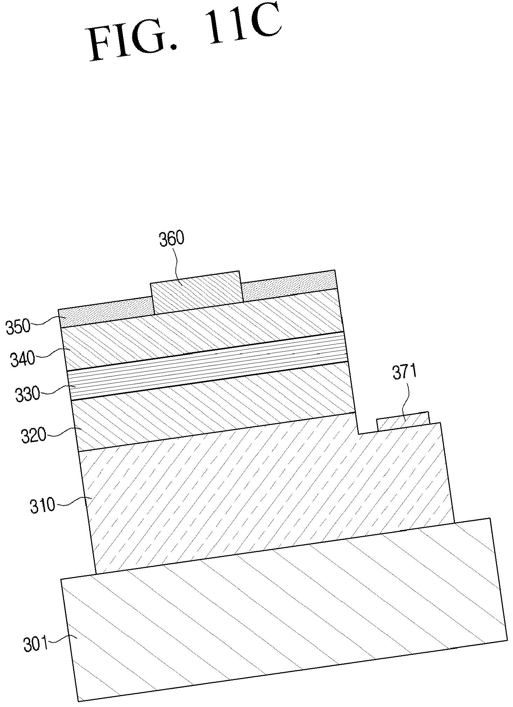

Referring to FIG. 11C, the current guiding part 350 may be formed on the second cladding layer 340 (S33).

In this case, the current guiding part 350 may be formed by forming a resist mask 360 on the second cladding layer 340, and patterning the resist mask 360 by using a laser lift-off process or a wet etching process. In this state, an insulating material may be formed on a portion of the second cladding layer 340, not covered by the resist mask 360.

The current guiding part 350 may be formed by depositing the insulating material on the second cladding layer 340 by using a suitable technique such as electron beam evaporation, sputtering, chemical vapor deposition, atomic layer deposition, or spin coating.

The current guiding part 350 may be formed, and the resist mask 360 may then be removed. The second electrode 373 described below may be formed at a position where the resist mask 360 is removed.

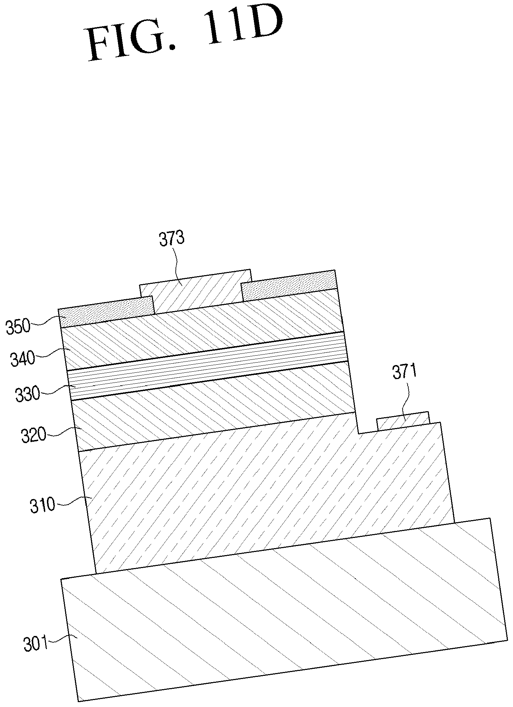

Referring to FIG. 11D, the first electrode 371 may be formed on the current spreading layer 310, and the second electrode 373 may be formed on the second cladding layer 340 (S34) .

The first electrode 371 and the second electrode 373 may be formed by, for example, the lift-off process.

Although not shown in the drawings, the semiconductor contact layer (not shown) may be positioned between the first electrode 371 and the current spreading layer 310, and between the second electrode 373 and second cladding layer 340, for their ohmic contacts. The semiconductor contact layer may be deposited on each of the current spreading layer 310 and the second cladding layer 340 by any of various techniques such as sputtering, evaporation, and spin coating.

The plurality of ultraviolet (UV) micro LEDs may be formed on the wafer 301 through this process.

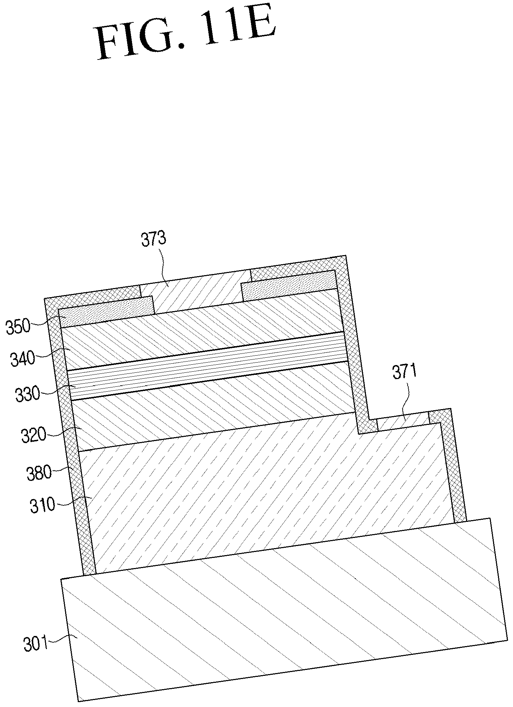

Referring to FIG. 11E, the passivation layer 380 may be formed on a surface of the UV micro LED (S35).

In this case, the passivation layer 380 may not cover the first electrode 371 or the second electrode 373 when stacked on the surface of the UV micro LED.

The passivation layer 380 may be made of a material such as alumina ($Al_2O_3$), silica ($SiO_2$), or silicon nitride (SiN). The passivation layer may be formed by any of various techniques such as atomic layer deposition, e-beam evaporation, sputtering, chemical vapor deposition, and spin coating.

Although not shown in the drawings, the passivation layer 280 may be formed, and a mirror layer such as a Distributed Bragg Reflector (DBR) may then be stacked on the passivation layer to improve light extraction efficiency of the micro LED.

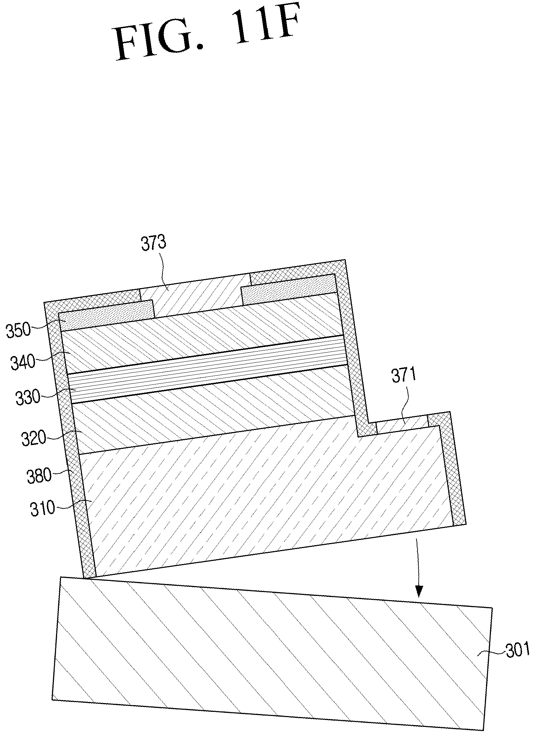

Referring to FIG. 11F, the plurality of micro LEDs 300 may be separated from the wafer 301 by irradiating a laser beam to a rear surface of the wafer 301 (S36).

Although not shown in the drawings, the plurality of micro LEDs 300 formed on the wafer 301 may be attached to one surface of a carrier substrate (not shown) before being separated from the wafer 301.

As described above, the micro LED of the present disclosure may include the current guiding part to control the current path applied to the second electrode and flowing to the current spreading layer to be spaced apart as far as possible from the side surface of the micro LED.

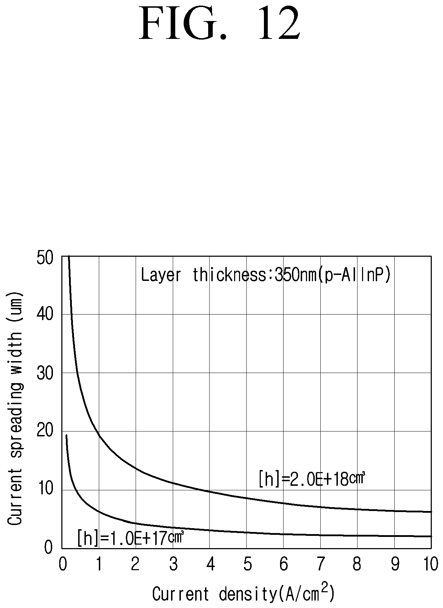

The micro LED of the present disclosure may have a small amount of current flowing along the second cladding layer because there is no current spreading layer between the current guiding part and the second cladding layer. For example, FIG. 12 shows a calculation result of the current spreading distance for a p-type AlInP layer having a thickness of 350 nm and a hole concentration of $1.0E+17/cm^3$ or $2.0E+18/cm^3$. Here, a current spreading distance Ws may be calculated using Equation 1 shown below.

[Equation 1]

$$Ws = \sqrt{\frac{t \cdot n \cdot k \cdot T}{\rho \cdot J \cdot e}}$$

In Equation 1, t is a thickness of the semiconductor layer, n is an ideality factor of the diode, k is the Boltzmann constant, T is a temperature, $\rho$ is resistivity of the semiconductor layer, J is a current density, and e is a basic charge.

The micro LED of the present disclosure may include the current guiding part in consideration of current spread in the second cladding layer. For example, the current spreading distance (Ws) is about 5 um in the second cladding layer when an operating current density is $1A/cm^2$, as shown in FIG. 12. Therefore, it is preferable to design the width of the current guiding part to be about 5 um or more from the side surface of the micro LED so that the current flow path is spaced apart from the side surface of the micro LED by about 5 um or more.

In this way, the micro LED of the present disclosure may include the current guiding part to control the current path in the active layer to be away from the side surface of the micro LED. Accordingly, the micro LED of the present disclosure may suppress the non-radiative recombination occurring on the side surface thereof, and thus have the improved luminous efficiency.

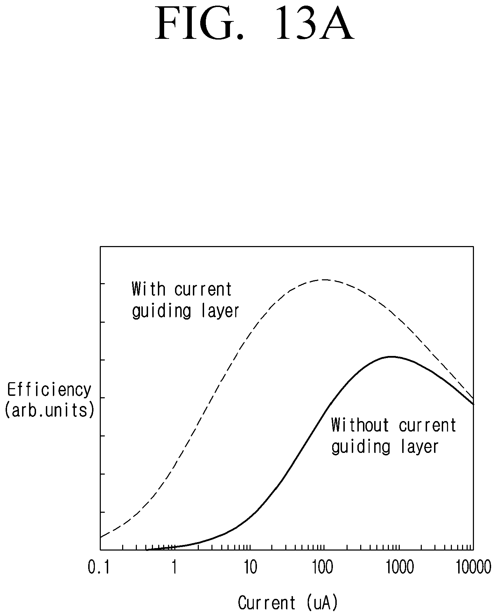

FIG. 13A is a graph showing an example of a simulation curve for a micro LED emitting red light according to the present disclosure. Referring to FIG. 13A, it may be seen that a conventional red micro LED exhibits low luminous efficiency, whereas the red micro LED of the present disclosure, including the current guide layer, has the greatly improved luminous efficiency.

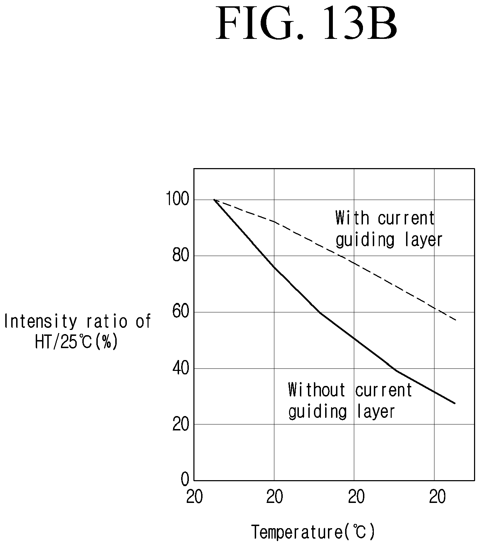

FIG. 13B is a graph showing an example of a temperature dependence of a light intensity for the red micro LED according to the present disclosure. Referring to FIG. 13B, it may be seen that the red micro LED according to the present disclosure suppresses the non-radiative recombination occurring on the side surface of the red micro LED by including the current guiding part, and thus has the improved thermal stability. In addition, it may be seen that the red micro LED including the current guide layer has the less thermal dependence.

Therefore, according to the present disclosure, it is possible to manufacture the self-luminous display module having the high color reproducibility, low power consumption, and high contrast ratio by using the micro LED having the high efficiency and thermal stability.

Although the embodiments of the present disclosure are shown and described hereinabove, the present disclosure is not limited to the above mentioned specific embodiments, and may be variously modified by those skilled in the art to which the present disclosure pertains without departing from the gist of the present disclosure as disclosed in the accompanying claims.

These modifications should also be understood to fall within the scope and spirit of the present disclosure.

[INDUSTRIAL APPLICABILITY]

The present disclosure relates to a micro light emitting diode (LED), a micro LED having the same, and a display module having the same.

**Claims**

1. A micro light emitting diode (LED) in which a first electrode and a second electrode are respectively disposed on a light-emitting surface thereof and a surface opposite to the light-emitting surface, the micro LED comprising:

   a current spreading layer electrically connected to the first electrode and having the light-emitting surface;
   a first cladding layer and a second cladding layer, stacked on the current spreading layer;
   an active layer disposed between the first cladding layer and the second cladding layer; and
   a current guiding part disposed between the second electrode and the second cladding layer, and positioned from a side surface of the micro LED to a position of the micro LED, adjacent to a central part thereof, for a current to flow away from the side surface of the micro LED.

2. The micro LED as claimed in claim 1, wherein the second electrode has a lateral length greater than a lateral length of an area of the current guiding part, through which the current passes, to cover the area through which the current passes and a portion of the current guiding part, adjacent to the area through which the current passes.

3. The micro LED as claimed in claim 2, wherein a semiconductor layer serves as the area of the current guiding part, through which the current passes.

4. The micro LED as claimed in claim 1, wherein a carrier concentration of the second cladding layer is less than $5E+17/cm^3$.

5. The micro LED as claimed in claim 3, wherein the first electrode and the second electrode are each made of any one of aluminum (Al), titanium (Ti), chromium (Cr), nickel (Ni), palladium (Pd), silver (Ag), germanium (Ge), gold (Au), or an alloy thereof.

6. The micro LED as claimed in claim 5, wherein a first semiconductor contact layer made of an electrically conductive oxide is positioned between the first electrode and the current spreading layer, and

a second semiconductor contact layer made of the electrically conductive oxide is positioned between the second electrode and the semiconductor layer.

7. The micro LED as claimed in claim 6, wherein the first and second semiconductor contact layers are each made of indium tin oxide (ITO) or zinc oxide (ZnO).

8. The micro LED as claimed in claim 1, further comprising a passivation layer stacked on the side surface of the micro LED, and
   the passivation layer is made of any one of alumina ($Al_2O_3$), silica ($SiO_2$), and silicon nitride (SiN).

9. The micro LED as claimed in claim 1, wherein the current guiding part is made of any one of alumina ($Al_2O_3$), silica ($SiO_2$), and silicon nitride (SiN).

10. The micro LED as claimed in claim 2, further comprising:

    a first semiconductor layer serving as the area of the current guiding part, through which the current passes; and
    a second semiconductor layer covering the first semiconductor layer and the current guiding part, and electrically connected to the second electrode.

11. The micro LED as claimed in claim 10, wherein a carrier concentration of the second semiconductor layer is greater than or equal to a carrier concentration of the second cladding layer.

12. The micro LED as claimed in claim 1, wherein the second electrode has a lower portion inserted into the current guiding part and electrically connected to the second cladding layer, and
    an upper portion protruding higher than an upper surface of the current guiding part and having a lateral length greater than a lateral length of an area through which the current passes to cover a portion adjacent to the area through which the current passes.

13. A micro light emitting diode (LED) in which a first electrode and a second electrode are respectively disposed on a light-emitting surface thereof and a surface opposite to the light-emitting surface, the micro LED comprising:

    a current spreading layer electrically connected to the first electrode and having the light-emitting surface;
    a first cladding layer and a second cladding layer, stacked on the current spreading layer;
    an active layer disposed between the first cladding layer and the second cladding layer;

a current guiding part disposed between the second electrode and the second cladding layer, and positioned from a side surface of the micro LED to a position of the micro LED, adjacent to a central part thereof, for a current to flow away from the side surface of the micro LED; and
a passivation layer stacked on the side surface of the micro LED,
wherein the second electrode has a lateral length greater than a lateral length of an area of the current guiding part, through which the current passes, to cover the area through which the current passes and a portion adjacent to the area through which the current passes.

14. The micro LED as claimed in claim 13, further comprising:

a first semiconductor layer serving as the area of the current guiding part, through which the current passes; and
a second semiconductor layer covering the first semiconductor layer and the current guiding part, and electrically connected to the second electrode,
wherein the second electrode has a lower portion inserted into the current guiding part and electrically connected to the second cladding layer, and an upper portion protruding higher than an upper surface of the current guiding part and having the lateral length greater than the lateral length of the area through which the current passes to cover the portion adjacent to the area through which the current passes.

15. A display module comprising:

a thin film transistor (TFT) substrate including a glass substrate and a TFT layer positioned on one surface of the glass substrate; and
a plurality of micro light emitting diodes (LEDs) electrically connected to a plurality of TFT electrodes positioned on the TFT layer,
wherein each of the plurality of micro LEDs has a first electrode and a second electrode on a surface opposite to a light-emitting surface thereof,
the micro LED includes:

a current spreading layer electrically connected to the first electrode and having the light-emitting surface;
a first cladding layer and a second cladding layer, stacked on the current spreading layer;
an active layer disposed between the first cladding layer and the second cladding layer;

a current guiding part disposed between the second electrode and the second cladding layer, and positioned from a side surface of the micro LED to a position of the micro LED, adjacent to a central part thereof, for a current to flow away from the side surface of the micro LED; and
a passivation layer stacked on the side surface of the micro LED, and
the second electrode has a lateral length greater than a lateral length of an area of the current guiding part, through which the current passes, to cover the area through which the current passes and a portion adjacent to the area through which the current passes.

# FIG. 1

# FIG. 2

# FIG. 3

# FIG. 4

```
          ┌──────────────┐
          │    START     │
          └──────────────┘
                  │
                  ▼
┌─────────────────────────────────────────┐
│ FORM SEMICONDUCTOR EPITAXIAL STRUCTURE   │──S11
└─────────────────────────────────────────┘
                  │
                  ▼
┌─────────────────────────────────────────┐
│              IMPLANT IONS                │──S12
└─────────────────────────────────────────┘
                  │
                  ▼
┌─────────────────────────────────────────┐
│         FORM CURRENT GUIDING PART        │──S13
└─────────────────────────────────────────┘
                  │
                  ▼
┌─────────────────────────────────────────┐
│           PERFORM MESA ETCHING           │──S14
└─────────────────────────────────────────┘
                  │
                  ▼
┌─────────────────────────────────────────┐
│             FORM ELECTRODES              │──S15
└─────────────────────────────────────────┘
                  │
                  ▼
┌─────────────────────────────────────────┐
│          FORM PASSIVATION LAYER          │──S16
└─────────────────────────────────────────┘
                  │
                  ▼
┌─────────────────────────────────────────┐
│             SEPARATE WAFER               │──S17
└─────────────────────────────────────────┘
                  │
                  ▼
          ┌──────────────┐
          │     END      │
          └──────────────┘
```

# FIG. 5A

150

140

130

120

110

101

# FIG. 5B

Ion implantation

151  160

153

140

130

120

110

101

# FIG. 5C

# FIG. 5D

# FIG. 5E

# FIG. 5F

# FIG. 6

# FIG. 7

```
              ┌─────────────┐
              │    START    │
              └─────────────┘
                     │
                     ▼
    ┌──────────────────────────────────────┐
    │  FORM SEMICONDUCTOR EPITAXIAL LAYER   │─── S21
    └──────────────────────────────────────┘
                     │
                     ▼
    ┌──────────────────────────────────────┐
    │          PERFORM MESA ETCHING         │─── S22
    └──────────────────────────────────────┘
                     │
                     ▼
    ┌──────────────────────────────────────┐
    │ OXIDIZE PORTION OF FIRST SEMICONDUCTOR│─── S23
    │                LAYER                  │
    └──────────────────────────────────────┘
                     │
                     ▼
    ┌──────────────────────────────────────┐
    │        FORM CURRENT GUIDING PART      │─── S24
    └──────────────────────────────────────┘
                     │
                     ▼
    ┌──────────────────────────────────────┐
    │            FORM ELECTRODES            │─── S25
    └──────────────────────────────────────┘
                     │
                     ▼
    ┌──────────────────────────────────────┐
    │         FORM PASSIVATION LAYER        │─── S26
    └──────────────────────────────────────┘
                     │
                     ▼
    ┌──────────────────────────────────────┐
    │            SEPARATE WAFER             │─── S27
    └──────────────────────────────────────┘
                     │
                     ▼
              ┌─────────────┐
              │     END     │
              └─────────────┘
```

# FIG. 8A

# FIG. 8B

# FIG. 8C

# FIG. 8D

# FIG. 8E

273 251
260
253
240
230
220
280
210
271
201

# FIG. 8F

# FIG. 9

Current flow

# FIG. 10

```
           ┌──────────┐
           │  START   │
           └────┬─────┘
                ▼
┌──────────────────────────────────────┐
│ FORM SEMICONDUCTOR EPITAXIAL LAYER    │──S31
└───────────────┬──────────────────────┘
                ▼
┌──────────────────────────────────────┐
│       PERFORM MESA ETCHING            │──S32
└───────────────┬──────────────────────┘
                ▼
┌──────────────────────────────────────┐
│     FORM CURRENT GUIDING PART         │──S33
└───────────────┬──────────────────────┘
                ▼
┌──────────────────────────────────────┐
│         FORM ELECTRODES               │──S34
└───────────────┬──────────────────────┘
                ▼
┌──────────────────────────────────────┐
│       FORM PASSIVATION LAYER          │──S35
└───────────────┬──────────────────────┘
                ▼
┌──────────────────────────────────────┐
│         SEPARATE WAFER                │──S36
└───────────────┬──────────────────────┘
                ▼
           ┌──────────┐
           │   END    │
           └──────────┘
```

# FIG. 11A

340

330

320

310

301

# FIG. 11B

340
330
320
310
301

# FIG. 11C

# FIG. 11D

# FIG. 11E

# FIG. 11F

# FIG. 12

# FIG. 13A

# FIG. 13B

Intensity ratio of
HT/25℃(%)

With current
guiding layer

Without current
guiding layer

100

80

60

40

20

0

20    20    20    20

Temperature(℃)

## INTERNATIONAL SEARCH REPORT

| International application No. |
| --- |
| **PCT/KR2021/010670** |

**A. CLASSIFICATION OF SUBJECT MATTER**

**H01L 33/24**(2010.01)i; **H01L 25/075**(2006.01)i; **H01L 33/36**(2010.01)i; **H01L 33/40**(2010.01)i; **H01L 33/44**(2010.01)i

According to International Patent Classification (IPC) or to both national classification and IPC

**B. FIELDS SEARCHED**

Minimum documentation searched (classification system followed by classification symbols)

H01L 33/24(2010.01); H01L 27/15(2006.01); H01L 33/00(2010.01); H01L 33/14(2010.01); H01L 33/22(2010.01); H01L 33/36(2010.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전류(current), 확산(diffusion), 가이딩(guiding), 클래딩(cladding), 전극(electrode)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2011-0132159 A (SAMSUNG LED CO., LTD.) 07 December 2011 (2011-12-07)<br>See paragraphs [0025]-[0034], and figures 1a-1f. | 1-15 |
| Y | JP 11-040892 A (FUJI ELECTRIC CO., LTD.) 12 February 1999 (1999-02-12)<br>See paragraphs [0017]-[0019], and figure 2. | 1-15 |
| Y | WO 2020-101381 A1 (SAMSUNG ELECTRONICS CO., LTD.) 22 May 2020 (2020-05-22)<br>See paragraphs [0063] and [0138], and figure 1. | 8,13-15 |
| Y | JP 11-074616 A (SONY CORP.) 16 March 1999 (1999-03-16)<br>See paragraphs [0012]-[0013], and figure 1. | 10-11,14 |
| A | KR 10-2013-0044909 A (SEOUL OPTO DEVICE CO., LTD.) 03 May 2013 (2013-05-03)<br>See entire document. | 1-15 |

☐ Further documents are listed in the continuation of Box C.    ☑ See patent family annex.

| * Special categories of cited documents: | |
| --- | --- |
| "A" document defining the general state of the art which is not considered to be of particular relevance | "T" later document published after the international filing date or priority date and not in conflict with the application but cited to understand the principle or theory underlying the invention |
| "D" document cited by the applicant in the international application | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **26 November 2021** | **26 November 2021** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

# EP 4 160 701 A1

## INTERNATIONAL SEARCH REPORT
### Information on patent family members

International application No.

**PCT/KR2021/010670**

| Patent document cited in search report | | | Publication date (day/month/year) | Patent family member(s) | | | Publication date (day/month/year) |
|---|---|---|---|---|---|---|---|
| KR | 10-2011-0132159 | A | 07 December 2011 | None | | | |
| JP | 11-040892 | A | 12 February 1999 | None | | | |
| WO | 2020-101381 | A1 | 22 May 2020 | CN | 112997323 | A | 18 June 2021 |
| | | | | EP | 3837722 | A1 | 23 June 2021 |
| | | | | KR | 10-2020-0057216 | A | 26 May 2020 |
| | | | | US | 11133431 | B2 | 28 September 2021 |
| | | | | US | 2020-0161499 | A1 | 21 May 2020 |
| JP | 11-074616 | A | 16 March 1999 | None | | | |
| KR | 10-2013-0044909 | A | 03 May 2013 | None | | | |

Form PCT/ISA/210 (patent family annex) (July 2019)

**REFERENCES CITED IN THE DESCRIPTION**

**Patent documents cited in the description**

- KR 1020200122896